# EUROPEAN PATENT SPECIFICATION

(11) **EP 4 155 814 B1**
(45) Date of publication and mention of the grant of the patent: **13.08.2025**
(21) Application number: 21833822.6
(22) Date of filing: 30.04.2021
(51) Int. Cl.: G02F 1/133, G02F 1/1335, H10K 50/818, H10K 50/85, H10K 59/50, H10K 59/65, H04M 1/02

(54) **DISPLAY SCREEN ASSEMBLY, ELECTRONIC DEVICE, AND IMAGE ACQUISITION METHOD**
ANZEIGEBILDSCHIRMANORDNUNG, ELEKTRONISCHE VORRICHTUNG UND BILDERFASSUNGSVERFAHREN
ENSEMBLE ÉCRAN D'AFFICHAGE, DISPOSITIF ÉLECTRONIQUE ET PROCÉDÉ D'ACQUISITION D'IMAGE

(30) Priority: 28.06.2020 CN 202010599855
(43) Date of publication of application: 29.03.2023
(73) Proprietor: GUANGDONG OPPO MOBILE TELECOMMUNICATIONS CORP., LTD., Dongguan, Guangdong 523860 (CN)
(72) Inventor: LI, Zhilin, Dongguan, Guangdong 523860 (CN)
(74) Representative: Tansini, Elio Fabrizio
(86) International application number: PCT/CN2021/091472
(87) International publication number: WO 2022/001350

(56) References cited:
- WO-A1-2019/201057
- WO-A1-2020/061845
- WO-A1-2020/095607
- WO-A1-2020/129735
- CN-A- 110 764 319
- CN-A- 110 780 375
- CN-A- 110 992 823
- CN-A- 110 993 675
- CN-A- 111 261 043
- CN-A- 111 722 430
- CN-U- 208 385 409

## Description

### TECHNICAL FIELD

The disclosure relates to the field of electronic technologies, and more particularly to a display screen assembly, an electronic device, and an image acquisition method.

### BACKGROUND

With the development of the electronic technologies, a size of a display screen in an electronic device such as a smart phone is getting larger and larger, and a screen-to-body ratio of the display screen is also getting higher and higher. In general, the display screen of the electronic device is disposed with a non-display area, which is used to set functional components such as a camera.

In order to further improve the screen-to-body ratio of the display screen, setting the camera below the display screen has gradually emerged in the related art. The camera receives external light passing through the display screen, so as to achieve image acquisition.

WO2019/201057A1 discloses a camera, which includes a camera lens group, an optical waveguide device, and a camera main body. One end of the optical waveguide device is connected to the camera lens group, the other end thereof is connected to the camera main body. The optical waveguide device is configured to transmit light acquired by the camera lens group to the camera main body.

WO2020/095607A1 discloses an electronic apparatus provided with a liquid crystal panel and an illumination device that illuminates the liquid crystal panel. The illumination device includes a first light guide plate, first light source, a second light guide plate and a second light source. The first light guide plate has a first opening including a notch or a through hole, and faces the liquid crystal panel. The first light source faces the first light guide plate. The second light guide plate is provided in the first opening and faces the liquid crystal panel. The second light source faces the second light guide plate.

### SUMMARY

Embodiments of the disclosure provides a display screen assembly, an electronic device, and an image acquisition method, which can improve image acquisition effects of the electronic device. The invention is set out in the appended set of claims.

### BRIEF DESCRIPTION OF DRAWINGS

In order to illustrate technical solutions in embodiments of the disclosure more clearly, the following will briefly introduce drawings needed in the description of the embodiments. Apparently, the drawings in the following description are merely some embodiments of the disclosure. For those skilled in the art, other drawings can be obtained from these drawings without any creative effort.
FIG. 1 illustrates a schematic structural view of a first structure of an electronic device according to an embodiment of the disclosure.
FIG. 2 illustrates a schematic structural view of a display screen assembly of the electronic device illustrated in FIG. 1.
FIG. 3 illustrates a schematic structural view of a first structure of a display screen of the display screen assembly illustrated in FIG. 2.
FIG. 4 illustrates a schematic structural view of a second structure of the display screen of the display screen assembly illustrated in FIG. 2.
FIG. 5 illustrates a schematic structural view of a third structure of the display screen of the display screen assembly illustrated in FIG. 2.
FIG. 6 illustrates a schematic view of propagation of light when passing through a coupling grating.
FIG. 7 illustrates a schematic view of a first kind of light propagation in the coupling grating of the display screen assembly illustrated in FIG. 2.
FIG. 8 illustrates a schematic view of a second kind of light propagation in the coupling grating of the display screen assembly illustrated in FIG. 2.
FIG. 9 illustrates a schematic structural view of a second structure of an electronic device according to an embodiment of the disclosure.
FIG. 10 illustrates a schematic structural view of a third structure of an electronic device according to an embodiment of the disclosure.
FIG. 11 illustrates a first schematic view of the electronic device acquiring an image according to the embodiment of the disclosure.
FIG. 12 illustrates a second schematic view of the electronic device acquiring the image according to the embodiment of the disclosure.
FIG. 13 illustrates a schematic structural view of a fourth structure of an electronic device according to an embodiment of the disclosure.

### DETAILED DESCRIPTION OF EMBODIMENTS

Technical solutions in embodiments of the disclosure will be described clearly and completely in combination with the drawings in the embodiments of the disclosure. Apparently, the described embodiments are merely some of the embodiments of the disclosure, not all of the embodiments.

An embodiment of the disclosure provides an electronic device. The electronic device may be a smart phone, a tablet computer, a game device, an augmented reality (AR) device, an automobile device, a data storage device, an audio playback device, a video playback device, a laptop computer, a desktop computing device, etc.

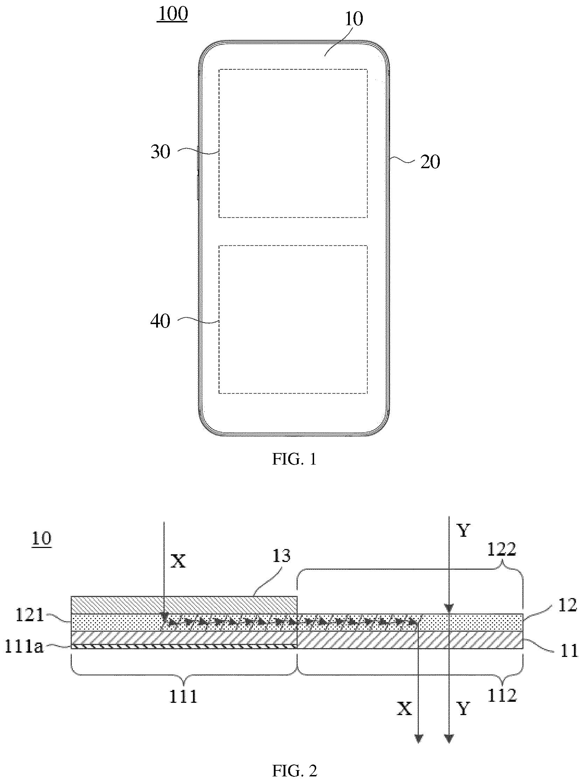

FIG. 1 illustrates a schematic structural view of a first structure of an electronic device according to an embodiment of the disclosure.

The electronic device 100 includes a display screen assembly 10, a housing 20, a circuit board 30, and a battery 40.

Specifically, the display screen assembly 10 is disposed on the housing 20 to form a display surface of the electronic device 100 for displaying information such as images and texts.

Understandably, the display screen assembly 10 may be disposed with a cover plate to protect the display screen assembly 10 and block the display screen assembly 10 from being scratched or damaged by water. The cover plate may be a transparent glass cover plate, so that a user can observe the content displayed by the display screen assembly 10 through the cover plate. For example, the cover plate may be a glass cover plate made of sapphire.

The housing 20 is used to form an external contour of the electronic device 100, so as to accommodate electronic components, functional components, and the like of the electronic device 100, and to seal and protect the electronic components and the functional components inside the electronic device. For example, the functional components such as a camera, a circuit board, and a vibration motor of the electronic device 100 may be disposed inside the housing 20.

The circuit board 30 is disposed inside the housing 20. Specifically, the circuit board 30 may be a main board of the electronic device 100. The circuit board 30 may be integrated with one or more of the functional components such as a processor, a headphone interface, an acceleration sensor, a gyroscope, and a motor. In this situation, the display screen assembly 10 may be electrically connected to the circuit board 30 to control the display of the display screen assembly 10 through the processor on the circuit board 30.

The battery 40 is disposed inside the housing 20. In this situation, the battery 40 is electrically connected to the circuit board 30 to realize that the battery 40 supplies power to the electronic device 100. The circuit board 30 may be disposed with a power management circuit. The power management circuit is used to distribute the voltage provided by the battery 40 to each electronic component in the electronic device 100.

FIG. 2 illustrates a schematic structural view of a display screen assembly of the electronic device illustrated in FIG. 1.

The display screen assembly 10 includes a display screen 11, a coupling grating 12, and an electrically-controlled light-passing device 13. The display screen 11, the coupling grating 12, and the electrically-controlled light-passing device 13 are sequentially stacked.

Specifically, the display screen 11 may be a liquid crystal display (LCD) or an organic light-emitting diode (OLED) or other type of display screen.

The display screen 11 includes a first region 111 and a second region 112. The first region 111 may be adjacent to the second region 112, as shown in FIG. 2. In other embodiments, the first region 111 may be disposed around a periphery of the second region 112. The light transmittance of the first region 111 is less than that of the second region 112. For example, the light transmittance of the first region 111 may be 2%, and the light transmittance of the second region 112 may be 20%.

In some embodiments, the first region 111 includes a reflective layer 111a. The reflective layer 111a is located on a side of the first region 111 facing away from the coupling grating 12. The reflective layer 111a is used to reflect light, for example, the light generated in the first region 111 is reflected, so that the light generated in the first region 111 is emitted toward a side of the coupling grating 12, thereby improving the brightness of the first region 111 when displaying information.

In the description of the disclosure, it should be understood that terms such as "first" and "second" are merely used to distinguish similar objects, and cannot be understood as indicating or implying relative importance or implicitly indicating the number of indicated technical features.

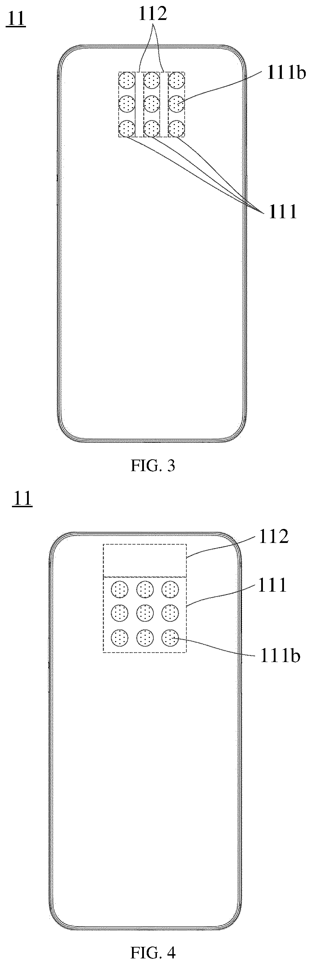

In some embodiments, FIG. 3 illustrates a schematic structural view of a first structure of a display screen of the display screen assembly illustrated in FIG. 2.

Specifically, the first region 111 is disposed with multiple pixels 111b. That is, the first region 111 includes multiple pixels 111b. It can be understood that, when the display screen 11 displays information, in order to make the light generated by the pixels 111b transmit to the outside of the electronic device as much as possible and reduce the loss of light in the electronic device, thereby ensuring the brightness of the display screen 11 when displaying information, a reflective layer may be set at a bottom of the multiple pixels 111b, and the light transmitted to the inside of the electronic device is reflected to the outside of the electronic device through the reflective layer. Therefore, the reflective layer 111a may be a reflective layer disposed at the bottom of the multiple pixels 111b of the first region 111. In practical application, the reflective layer 111a may be anodes at the bottom of the multiple pixels 111b. That is, the reflective layer 111a includes the anodes of the multiple pixels 111b of the first region 111. When the anodes at the bottom of the multiple pixels 111b is used as the reflective layer, the reflectivity can be close to 100%. Therefore, the light transmittance of the pixels 111b are close to 0. In this situation, it can be understood that the light transmittance of the first region 111 is also close to 0.

The second region 112 is not disposed with pixels. As shown in FIG. 3, the second region 112 is a gap region formed by the multiple pixels 111b. It can be understood that the first region 111 is surrounding a periphery of the second region 112 at this time. Since the second region 112 is not disposed with the pixels with the light transmittance close to 0, the light transmittance of the second region 112 is high. In addition, the second region 112 may be disposed with some electronic , such as a pixel driving circuit, and the pixel driving circuit may be made of materials with high light transmittance (such as indium tin oxide abbreviated as ITO) to ensure the light transmittance of the second region 112. It can be understood that the pixel driving circuit may be a driving circuit of the multiple pixels 111b.

In some embodiments, FIG. 4 illustrates a schematic structural view of a second structure of the display screen of the display screen assembly illustrated in FIG. 2.

A difference between the display screen 11 shown in FIG. 4 and that shown in FIG. 3 is that the second region 112 may be separately disposed. That is, the second region 112 is not formed by the gap region between the multiple pixels 111b, but is separately disposed outside the first region 111. For example, the second region 112 may be disposed beside the first region 111 and connected to the first region 111.

The second region 112 may not be disposed with pixels, but the second region 112 may still be disposed with components with high light transmittance such as a pixel driving circuit, and in this case, the second region 112 cannot display information. It can be understood that the second region 112 may be disposed at an edge of the display screen 11. In practical application, a size of the second region 112 may be set smaller, so as to reduce the influence on the display function of the entire display screen 11.

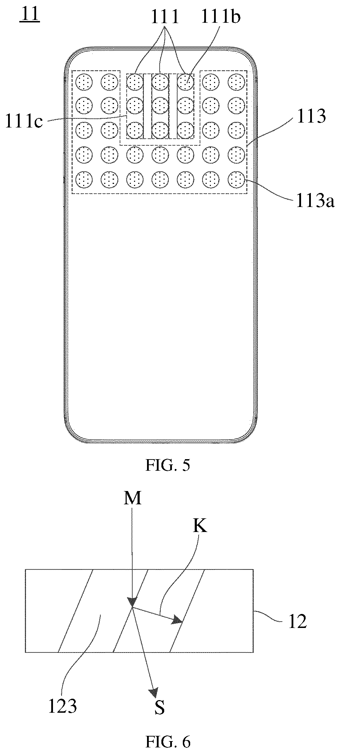

In some embodiments, FIG. 5 illustrates a schematic structural view of a third structure of the display screen of the display screen assembly illustrated in FIG. 2.

The display screen 11 further includes a third region 113. The third region 113 may be disposed at a periphery of the first region 111. The third region 113 is disposed with multiple pixels 113a, and thus the third region 113 can also display information normally. The pixel driving circuit of the first region 111 may be disposed in the third region 113, and the pixel driving circuit of the first region 111 is the driving circuit of the multiple pixels 111b. Therefore, the pixel driving circuit of the multiple pixels 111b does not need to be disposed in the second region 112, so as to further improve the light transmittance of the second region 112.

In some embodiments, the multiple pixels 111b of the first region 111 may form multiple pixel groups 111c. That is, the first region 111 includes multiple pixel groups 111c. Each of the multiple pixel groups 111c includes at least two pixels 111b, and the pixels in each of the multiple pixel groups 111c are connected in parallel.

It can be understood that a pixel density of the third region 113 may be equal to that of the first region 111. When the multiple pixels 111b in the first region 111 are formed into the multiple pixel groups 111c and the pixels in each of the multiple pixel groups 111c are connected in parallel, the parallel pixels in each of the multiple pixel groups 111c may share driving lines. Therefore, the number of driving lines required for the multiple pixels 111b can be reduced, thereby simplifying the driving circuit of the first region 111 as a whole, and facilitating the driving circuit of the first region 111 to be disposed in the third region 113.

As shown in FIG. 2, the coupling grating 12 is disposed on a side of the display screen 11. For example, the coupling grating 12 may be disposed on a display side of the display screen 11. It can be understood that the display side is a side of the display screen 11 that displays information, and can also be understood as a side of the light emitted by an internal light source of the display screen 11.

Specifically, the coupling grating 12 is disposed opposite to the display screen 11. The coupling grating 12 couples and transmits an external light being incident toward the first region 111 of the display screen 11 to be incident toward the second region 112, and emits the external light from the second region 112. It should be noted that the external light refers to light in an external environment, such as sunlight, light emitted by a fluorescent lamp (also referred to as daylight lamp), etc., instead of the light generated by the internal light source of the display screen 11.

The coupling grating 12 includes a first coupling region 121 and a second coupling region 122. The first coupling region 121 is opposite to the first region 111 of the display screen 11, and the second coupling region 122 is opposite to the second region 112 of the display screen 11. The external light being incident on the first coupling region 121 is coupled and transmitted to the second coupling region 122, and emitted from the second coupling region 122 toward the second region 112. Thus, the coupling grating 12 can realize coupling and transmitting the external light being incident toward the first region 111 to be incident toward the second region 112.

For example, as shown in FIG. 2, when the external light X is incident toward the first region 111 of the display screen 11, the external light X is first transmitted to the coupling grating 12, then the external light X is coupled and transmitted by the coupling grating 12 to be incident toward the second region 112 of the display screen 11, and is emitted from the second region 112. That is, the external light X being incident toward the first region 111 is offset by the coupling grating 12 to be incident toward the second region 112, and is emitted from the second region 112.

In addition, the coupling grating 12 further allows an external light being incident toward the second region 112 of the display screen 11 to be transmitted to the second region 112 through the coupling grating 12 and emitted from the second region 112.

For example, as shown in FIG. 2, when the external light Y is incident toward the second region 112 of the display screen 11, the external light Y is first transmitted to the coupling grating 12, and then the external light Y is transmitted to the second region 112 through the coupling grating 12, and is emitted from the second region 112.

FIG. 6 illustrates a schematic view of propagation of light when passing through the coupling grating 12.

The coupling grating 12 includes a periodic grating structure 123. When the external light is transmitted to the coupling grating 12, refraction and transmission occur at the grating structure 123. For example, when the external light M is transmitted to the coupling grating 12, the external light M refracts at the grating structure 123 to form a refracted light (also referred to as refracted ray) K, and transmits to form a transmitted light S. The refracted light K continues to transmit inside the coupling grating 12, and continues to refract at the next grating structure. Since the refracted light K refracts continuously inside the coupling grating 12, the light transmission path is changed. The transmitted light S passes through the coupling grating 12 and is transmitted to the inside of the electronic device, and finally is lost in the electronic device.

It should be noted that with the maturity of coupling grating technology and manufacturing process, the optical performance of the coupling grating can be relatively excellent. In this situation, when the external light refracts and transmits in the coupling grating 12, the refracted light K formed is stronger, while the transmitted light S formed is weaker. Therefore, when the external light passes through the coupling grating 12, the loss of the external light is small, and thus information carried by the external light can be obtained through the refracted light K. The transmission and utilization of the refracted light K are analyzed and described in the present disclosure, and the transmitted light S is ignored.

It should also be noted that the coupling grating 12 in the embodiment of the disclosure may be disposed with a periodic grating structure in a partial region of the first coupling region 121 and the second coupling region 122, and a grating structure is not provided in other regions of the second coupling region 122. Therefore, the region disposed with the periodic grating structure in the coupling grating 12 can couple and transmit the external light, such as the external light X in FIG. 2, while the region not disposed with the grating structure can allow the external light to pass through directly, such as the external light Y in FIG. 2.

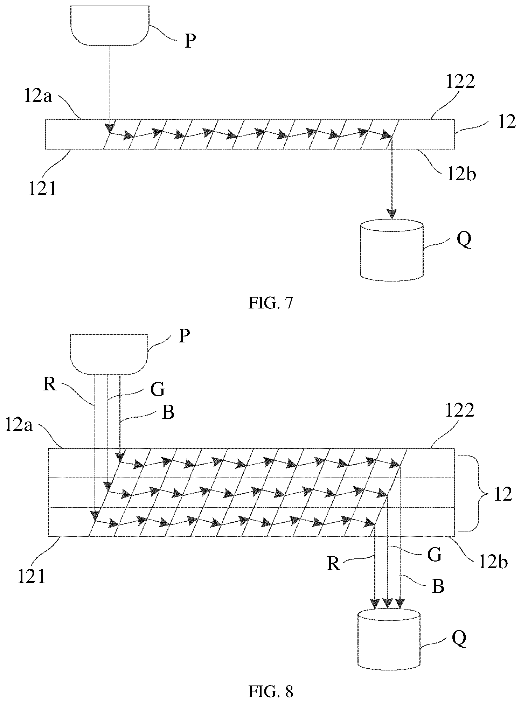

FIG. 7 illustrates a schematic view of a first kind of light propagation in the coupling grating 12 of the display screen assembly illustrated in FIG. 2.

The coupling grating 12 includes an entrance pupil surface 12a and an exit pupil surface 12b. The entrance pupil surface 12a may be understood as a light incident surface of the coupling grating 12, and the exit pupil surface 12b may be understood as a light emitting surface of the coupling grating 12.

When the external light emitted by a light source P is transmitted to the first coupling region 121 of the coupling grating 12, the external light is incident into an interior of the coupling grating 12 from the entrance pupil surface 12a, then transmitted to the second coupling region 122 from the first coupling region 121 in the coupling grating 12, and then the external light is emitted from the exit pupil surface 12b from the second coupling region 122 and transmitted to an optical imaging device Q, so that the optical imaging device Q can obtain an image of the light source P.

It should be noted that although the light source refers to an object that can emit light, such as the sun, the fluorescent lamp and other light sources, any object that can reflect light can be understood as a light source in practical application. For example, when a building reflects sunlight to form reflected light, the building can be understood as a light source, so that an image of the building can be obtained through the optical imaging device. For another example, when the human body reflects sunlight to form reflected light, the human body can also be understood as a light source, so that an image of the human body can be obtained through the optical imaging device.

FIG. 8 illustrates a schematic view of a second kind of light propagation in the coupling grating 12 of the display screen assembly illustrated in FIG. 2.

The external light emitted by the light source P may be mixed color light, for example, the external light emitted by the light source P may include color lights such as red (R), green (G), and blue (B). The coupling grating 12 may be a multi-layer structure. When R, G, B, and other color lights are transmitted to the interior of the coupling grating 12, the R, G, B and other color lights may be refracted at different parts inside the coupling grating 12, and finally emitted from the second coupling region 122 and transmitted to the optical imaging device Q.

As shown in FIG. 2, the electrically-controlled light-passing device 13 is disposed on a side of the coupling grating 12 facing away from the display screen 11, it can also be understood that the electrically-controlled light-passing device 13 is disposed on a side facing the user when the display screen assembly 10 displays information.

The electrically-controlled light-passing device 13 is opposite to the first region 111 of the display screen 11. It can be understood that the electrically-controlled light-passing device 13 is also opposite to the first coupling region 121 of the coupling grating 12. The electrically-controlled light-passing device 13 allows the external light to be incident toward the first region 111 of the display screen 11, or blocks the external light from being incident toward the first region 111.

Since the external light is first transmitted to the coupling grating 12 when the external light is incident on the display screen 11, the electrically-controlled light-passing device 13 can also be understood as allowing the external light to be incident toward the first coupling region 121 of the coupling grating 12, or blocking the external light from being incident toward the first coupling region 121.

The electrically-controlled light-passing device 13 is understood as a control switch for external light transmission. The electrically-controlled light-passing device 13 has a light-shielding state and a light-transmitting state, and is switchable between the light-shielding state and the light-transmitting state. In the light-shielding state, the electrically-controlled light-passing device 13 does not allow the external light to pass through; and in the light-transmitting state, the electrically-controlled light-passing device 13 allows the external light to pass through.

When the electrically-controlled light-passing device 13 is turned on, the electrically-controlled light-passing device 13 is in a light-shielding state, and in this situation, the electrically-controlled light-passing device 13 blocks the external light from being incident toward the first region 111 of the display screen 11. When the electrically-controlled light-passing device 13 is turned off, the electrically-controlled light-passing device 13 is in a light-transmitting state, and in this situation, the electrically-controlled light-passing device 13 allows the external light to pass through the electrically-controlled light-passing device 13 and to be incident toward the first region 111.

Therefore, it can be understood that when the electrically-controlled light-passing device 13 is turned on, the external light cannot be transmitted to the first coupling region 121 of the coupling grating 12. When the electrically-controlled light-passing device 13 is turned off, the external light can be transmitted to the first coupling region 121 of the coupling grating 12 through the electrically-controlled light-passing device 13, then transmitted from the first coupling region 121 to the second coupling region 122, and transmitted from the second coupling region 122 to the second region 112 of the display screen 11 and finally emitted from the second region 112.

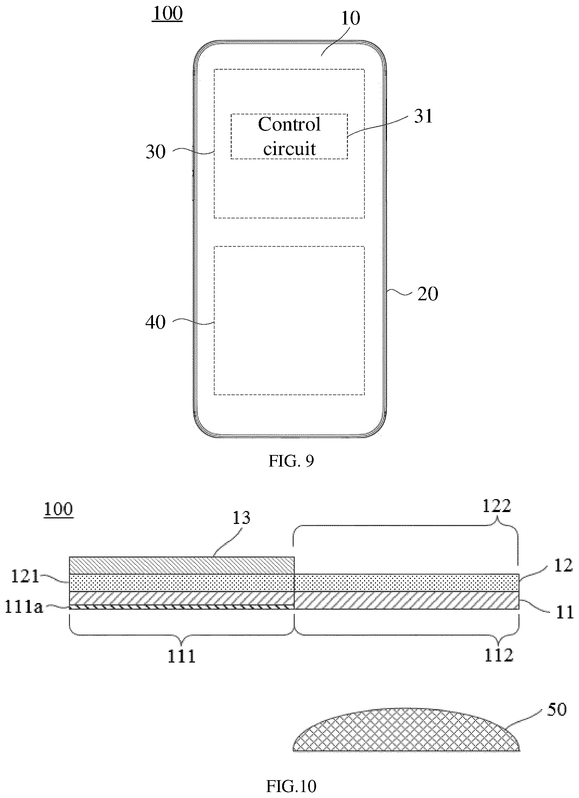

FIG. 9 illustrates a schematic structural view of a second structure of an electronic device 100 according to an embodiment of the disclosure.

The electronic device 100 further includes a control circuit 31. The control circuit 31 may, for example, be disposed on the circuit board 30. The control circuit 31 is electrically connected to the electrically-controlled light-passing device 13. The control circuit 31 is used to control the electrically-controlled light-passing device 13 to be turned on or turned off, so that the electrically-controlled light-passing device 13 allows the external light to be incident toward the first region 111 of the display screen 11 or blocks the external light from being incident toward the first region 111.

It can be understood that the control circuit 31 may include a high-frequency switching switch, such as a switching tube, to switch on or off the electrically-controlled light-passing device 13 through the high-frequency switching switch.

FIG. 10 illustrates a schematic structural view of a third structure of an electronic device according to an embodiment of the disclosure.

The electronic device 100 further includes an optical imaging device 50 for acquiring an image. The optical imaging device 50 may be, for example, a camera, a video camera, or the like. The optical imaging device 50 is disposed on a side of the display screen 11. It can be understood that in order to realize the hiding of the optical imaging device 50 in the electronic device 100, the optical imaging device 50 may be disposed on a non-display side of the display screen 11. Specifically, the non-display side is a side of the display screen 11 that does not display information, that is, a side of the display screen 11 facing the inside of the electronic device. For the entire electronic device 100, the optical imaging device 50 is disposed at a bottom of the display screen 11, and thus the optical imaging device 50 is invisible to the user.

The optical imaging device 50 is opposite to the second region 112 of the display screen 11. The optical imaging device 50 is used for receiving the external light emitted from the second region 112 to obtain an image.

It can be understood that the external light being incident on the first region 111 of the display screen 11 is emitted from the second region 112 after being coupled and transmitted by the coupling grating 12 and transmitted to the optical imaging device 50. The external light being incident toward the second region 112 is transmitted to the optical imaging device 50 after sequentially passing through the second coupling region 122 of the coupling grating 12 and the second region 112.

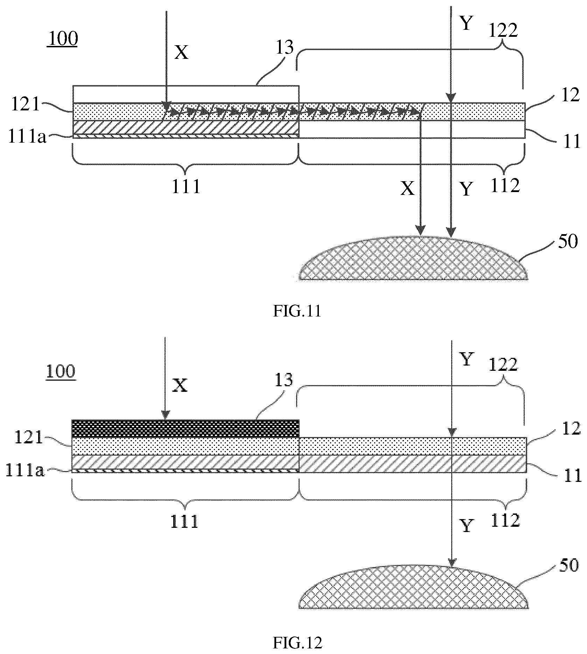

FIG. 11 illustrates a first schematic view of the electronic device acquiring an image according to the embodiment of the disclosure.

It can be understood that since the optical imaging device 50 is opposite to the second region 112 of the display screen 11, and the external light can pass through the second region 112, the optical imaging device 50 can receive the external light passing through the second region 112, so as to obtain an image corresponding to the external light. For example, the optical imaging device 50 can receive the external light passing through the second region 112 to realize functions such as photographing and video recording.

When the electrically-controlled light-passing device 13 is turned off, that is, when the electrically-controlled light-passing device 13 allows the external light to be incident toward the first region 111 of the display screen 11, the optical imaging device 50 acquires a first image.

For example, when the external light X is incident toward the first region 111 of the display screen 11, the electrically-controlled light-passing device 13 allows the external light X to pass through. Then, the external light X is transmitted to the first coupling region 121 of the coupling grating 12, and is coupled and transmitted from the first coupling region 121 to the second coupling region 122 and then emitted from the second coupling region 122 and transmitted to the second region 112 of the display screen 11. Finally, the external light X is emitted from the second region 112 and received by the optical imaging device 50.

In addition, when the external light Y is incident toward the second region 112 of the display screen 11, the external light Y sequentially passes through the second coupling region 122 and the second region 112, and is emitted from the second region 112 and received by the optical imaging device 50.

Therefore, the first image acquired by the optical imaging device 50 includes an image corresponding to the external light X and an image corresponding to the external light Y, and the image corresponding to the external light X overlaps with the image corresponding to the external light Y.

FIG. 12 illustrates a second schematic view of the electronic device acquiring the image according to the embodiment of the disclosure.

When the electrically-controlled light-passing device 13 is turned on, that is, when the electrically-controlled light-passing device 13 blocks the external light from being incident toward the first region 111 of the display screen 11, the optical imaging device 50 acquires a second image.

For example, when the external light X is incident toward the first region 111 of the display screen 11, the electrically-controlled light-passing device 13 blocks the transmission of the external light X. Therefore, the external light X cannot continue to be transmitted.

When the external light Y is incident toward the second region 112 of the display screen 11, the external light Y sequentially passes through the second coupling region 122 and the second region 112, and is emitted from the second region 112 and received by the optical imaging device 50.

Therefore, the second image acquired by the optical imaging device 50 includes the image corresponding to the external light Y, but does not include the image corresponding to the external light X.

Understandably, in a real image corresponding to the external light X and the external light Y, the image corresponding to the external light X and the image corresponding to the external light Y should be parts of the real image respectively, and the two images do not overlap. The two images are spliced together as a complete real image.

Therefore, in order to acquire the complete real image, after the optical imaging device 50 acquires the first image and the second image respectively, the electronic device 100 can generate a final image according to the first image and the second image. The final image is the complete real image.

For example, the electronic device 100 can remove image information corresponding to the second image from the first image to obtain a third image. It can be understood that since the first image includes the image corresponding to the external light X and the image corresponding to the external light Y, the second image includes the image corresponding to external light Y, the third image is the image corresponding to external light X.

Then, the electronic device 100 can splice the second image with the third image to obtain the final image.

When removing the image information corresponding to the second image from the first image, the electronic device 100 can process each pixel point of the first image in turn, for example, subtracting a pixel value of a corresponding pixel point of the second image from a pixel value of each pixel point of the first image. After the pixel value of the corresponding pixel point of the second image is successively subtracted from the pixel value of each pixel point of the first image, the pixel value of the pixel point obtained is the pixel value of each pixel point of the third image.

In addition, it can be understood that when the electronic device 100 processes each pixel point of the first image, the first image and the second image can be converted into grayscale images first, and then processed. Moreover, after the first image and the second image are converted into the grayscale images, if the grayscale of the converted first image is different from that of the converted second image, the converted first image and the converted second image can also be adjusted to the same grayscale, and then processed.

In practical application, the electronic device 100 may first control the electrically-controlled light-passing device 13 to be turned off through the control circuit 31 when photographing or video recording is required, so that the electrically-controlled light-passing device 13 allows the external light to pass through, and then the first image is acquired through the optical imaging device 50. Then, the control circuit 31 controls the electrically-controlled light-passing device 13 to be turned on, so that the electrically-controlled light-passing device 13 blocks the transmission of the external light, and then the second image is acquired through the optical imaging device 50. Finally, the electronic device 100 can generate the final image, that is, the complete real image, according to the first image and the second image.

It should be noted that when the electrically-controlled light-passing device 13 is turned on, the electrically-controlled light-passing device 13 does not allow light to pass through, and in this situation, the light generated in the first region 111 of the display screen 11 cannot be transmitted to the outside, so the first region 111 cannot display information normally. Therefore, the electronic device 100 can turn off the display function of the first region 111 when photographing or video recording is required, or turn off the display function of the first region 111 while the electrically-controlled light-passing device 13 is controlled to be turned on.

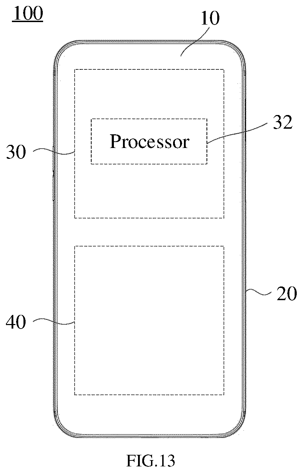

FIG. 13 illustrates a schematic structural view of a fourth structure of an electronic device 100 according to an embodiment of the disclosure.

The electronic device 100 further includes a processor 32. The processor 32 may, for example, be disposed on the circuit board 30. The processor 32 is electrically connected to the optical imaging device 50. When the optical imaging device 50 acquires the first image and the second image respectively, the processor 32 may be used to generate the final image according to the first image and the second image.

For example, the processor 32 may be used to remove the image information corresponding to the second image from the first image to obtain the third image, and to splice the second image with the third image to obtain the final image.

An embodiment of the disclosure provides an image acquisition method, which is applied to the above electronic device 100. The specific implementation of the image acquisition method may refer to the description of the above embodiments, and will not be repeated herein.

Specifically, the embodiment of the disclosure provides the image acquisition method, which is applied to the electronic device, and the electronic device includes:
a display screen assembly, comprising:
a display screen, including a first region and a second region, and light transmittance of the first region being less than light transmittance of the second region;
a coupling grating, disposed on a side of the display screen, wherein the coupling grating is configured to couple and transmit an external light being incident toward the first region to the second region and emitted from the second region; and
an electrically-controlled light-passing device, disposed on a side of the coupling grating facing away from the display screen, wherein the electrically-controlled light-passing device is opposite to the first region, and the electrically-controlled light-passing device is configured to allow the external light to be incident toward the first region or block the external light from being incident toward the first region; and
an optical imaging device, disposed on another side of the display screen, wherein the optical imaging device is opposite to the second region, and the optical imaging device is configured to receive the external light emitted from the second region.

The image acquisition method includes:
acquiring, in response to the electrically-controlled light-passing device being turned off, a first image through the optical imaging device;
acquiring, in response to the electrically-controlled light-passing device being turned on, a second image through the optical imaging device; and
generating a final image according to the first image and the second image.

In some embodiments, the generating a final image according to the first image and the second image includes:
removing image information corresponding to the second image from the first image to obtain a third image; and
splicing the second image and the third image to obtain the final image.

In the claimed invention, when the electrically-controlled light-passing device is turned on, the electrically-controlled light-passing device is in a light-shielding state to block the external light from being incident toward the first region; and
when the electrically-controlled light-passing device is turned off, the electrically-controlled light-passing device is in a light-transmitting state to allow the external light to pass through the electrically-controlled light-passing device and be incident toward the first region.

In some embodiments, the electronic device further includes a control circuit electrically connected to the electrically-controlled light-passing device.

In some embodiments, the acquiring, in response to the electrically-controlled light-passing device being turned off, a first image through the optical imaging device includes:
controlling, through the control circuit, the electrically-controlled light-passing device to be turned off to acquire the first image through the optical imaging device.

The acquiring, in response to the electrically-controlled light-passing device being turned on, a second image through the optical imaging device includes:
controlling, through the control circuit, the electrically-controlled light-passing device to be turned on to acquire the second image through the optical imaging device.

The electronic device 100 according to the embodiment of the disclosure can acquire the first image when the electrically-controlled light-passing device 13 allows the external light to pass through. The first image includes the image corresponding to the external light being incident toward the first region 111 of the display screen 11 and the image corresponding to the external light being incident toward the second region 112 of the display screen 11. When the electrically-controlled light-passing device 13 blocks the external light from passing through, the second image is acquired. The second image includes the image corresponding to the external light being incident toward the second region 112, but does not include the image corresponding to the external light being incident toward the first region 111. Finally, the final image is acquired according to the first image and the second image, and therefore the optical imaging device 50 can avoid acquiring the external image through the first region 111. Since the light transmittance of the first region 111 is less than that of the second region 112, the influence of the first region 111 with smaller light transmittance on the acquired image can be avoided, and thus the effect of acquiring the image can be improved.

The display screen assembly, the electronic device, and the image acquisition method according to the embodiments of the disclosure are described in detail above. The principles and implementations of the disclosure are described herein with specific examples.

## Claims

1. A display screen assembly (10), comprising:
a display screen (11), comprising a first region (111) and a second region (112), and light transmittance of the first region (111) being less than light transmittance of the second region (112);
a coupling grating (12), stacked on a side of the display screen (11), wherein the coupling grating (12) is configured to couple and transmit an external light being incident toward the first region (111) to the second region (112) and pass through the second region (112); and
an electrically-controlled light-passing device (13), stacked on a side of the coupling grating (12) facing away from the display screen (11), wherein the electrically-controlled light-passing device (13) faces to the first region (111), and is switchable between a light-shielding state and a light-transmitting state;
when the electrically-controlled light-passing device (13) is turned off, the electrically-controlled light-passing device (13) is in the light-transmitting state and is configured to allow the external light to be incident toward the first region (111); and when the electrically-controlled light-passing device (13) is turned on, the electrically-controlled light-passing device (13) is in the light-shielding state and is configured to block the external light from being incident toward the first region (111).

2. The display screen assembly (10) according to claim 1, wherein the coupling grating (12) comprises a first coupling region (121) and a second coupling region (122), the first coupling region (121) faces to the first region (111), the second coupling region (122) faces to the second region (112), the external light being incident to the first coupling region (121) is coupled and transmitted to the second coupling region (122), and the external light is emitted from the second coupling region (122) toward the second region (112).

3. The display screen assembly (10) according to claim 1, wherein the coupling grating (12) is further configured to allow an external light being incident toward the second region (112) to be transmitted to the second region (112) through the coupling grating (12) and pass through the second region (112).

4. The display screen assembly (10) according to claim 1, wherein the first region (111) is disposed with a plurality of pixels (111b); and the second region (112) is not disposed with pixels, and
wherein the second region (112) is a gap region formed by the plurality of pixels.

5. The display screen assembly (10) according to claim 4, wherein the display screen (11) further comprises a third region (113) disposed at a periphery of the first region (111), the third region (113) is disposed with a plurality of pixels (113a), and a pixel driving circuit of the first region (111) is disposed in the third region (113).

6. The display screen assembly (10) according to claim 5, wherein the first region (111) comprises a plurality of pixel groups (111c), each of the plurality of pixel groups (111c) comprises at least two pixels of the plurality of the pixels, and the at least two pixels in the each of the plurality of pixel groups (111c) are connected in parallel.

7. The display screen assembly (10) according to claim 6, wherein a pixel density of the third region (113) is equal to a pixel density of the first region (111).

8. The display screen assembly (10) according to claim 4, wherein a reflective layer (111a) is disposed at a bottom of the plurality of pixels (111b) in the first region (111).

9. The display screen assembly (10) according to claim 8, wherein the reflective layer (111a) comprises anodes of the plurality of pixels (111b) of the first region (111).

10. An electronic device (100), comprising:
the display screen assembly (10) according to any one of claims 1 to 9;
an optical imaging device (50), disposed on another side of the display screen (11), wherein the optical imaging device (50) faces to the second region (112), and the optical imaging device (50) is configured to receive external light passed through the second region (112) to thereby obtain an image.

11. The electronic device (100) according to claim 10, further comprising:
a control circuit (31), electrically connected to the electrically-controlled light-passing device (13), wherein the control circuit (31) is configured to control the electrically-controlled light-passing device (13) to be turned on or turned off, to thereby make the electrically-controlled light-passing device (13) allow the external light to be incident toward the first region (111) or block the external light from being incident toward the first region (111).

12. The electronic device (100) according to claim 10, wherein the optical imaging device (50) is configured to acquire a first image in response to the electrically-controlled light-passing device (13) allowing the external light to be incident toward the first region (111); and the optical imaging device (50) is configured to acquire a second image in response to the electrically-controlled light-passing device (13) blocking the external light from being incident toward the first region (111);
wherein the electronic device (100) further comprises:
a processor (32), electrically connected to the optical imaging device (50), and the processor (32) is configured to generate a final image according to the first image and the second image.

13. An image acquisition method, applied to the electronic device (100) according to any one of claims 10 to 12, and
wherein the image acquisition method comprises:
acquiring, in response to the electrically-controlled light-passing device (13) being turned off, a first image through the optical imaging device (50);
acquiring, in response to the electrically-controlled light-passing device (13) being turned on, a second image through the optical imaging device (50); and
generating a final image according to the first image and the second image.

14. The image acquisition method according to claim 13, wherein the generating a final image according to the first image and the second image comprises:
removing image information corresponding to the second image from the first image to obtain a third image; and
splicing the second image and the third image to obtain the final image.

## Patentansprüche

1. Anzeigebildschirm-Baugruppe (10), umfassend:
einen Anzeigebildschirm (11), umfassend eine erste Region (111) und eine zweite Region (112), und wobei eine Lichtdurchlässigkeit der ersten Region (111) kleiner als eine Lichtdurchlässigkeit der zweiten Region (112) ist;
ein Kopplungsgitter (12), das auf einer Seite des Anzeigebildschirms (11) gestapelt ist, wobei das Kopplungsgitter (12) konfiguriert ist, ein externes Licht, das hin zu der ersten Region (111) einfällt, zu der zweiten Region (112) zu koppeln und zu übertragen und durch die zweite Region (112) durchzulassen; und
eine elektrisch gesteuerte lichtdurchlässige Vorrichtung (13), die auf einer Seite des Kopplungsgitters (12), die weg von dem Anzeigebildschirm (11) weist, gestapelt ist, wobei die elektrisch gesteuerte lichtdurchlässige Vorrichtung (13) zu der ersten Region (111) weist und zwischen einem Licht abschirmenden Zustand und einem Licht übertragenden Zustand umschaltbar ist;
wenn die elektrisch gesteuerte lichtdurchlässige Vorrichtung (13) ausgeschaltet ist, ist die elektrisch gesteuerte lichtdurchlässige Vorrichtung (13) in dem Licht übertragenden Zustand und ist konfiguriert, dem externen Licht zu gestatten, hin zu der ersten Region (111) einzufallen; und wenn die elektrisch gesteuerte lichtdurchlässige Vorrichtung (13) eingeschaltet ist, ist die elektrisch gesteuerte lichtdurchlässige Vorrichtung (13) in dem Licht abschirmenden Zustand und ist konfiguriert, das externe Licht zu blockieren, hin zu der ersten Region (111) einzufallen.

2. Anzeigebildschirm-Baugruppe (10) nach Anspruch 1, wobei das Kopplungsgitter (12) eine erste Kopplungsregion (121) und eine zweite Kopplungsregion (122) umfasst, die erste Kopplungsregion (121) zu der ersten Region (111) weist, die zweite Kopplungsregion (122) zu der zweiten Region (112) weist, das externe Licht, das in die erste Kopplungsregion (121) einfällt, an die zweite Kopplungsregion (122) gekoppelt ist und dorthin übertragen wird, und das externe Licht von der zweiten Kopplungsregion (122) hin zu der zweiten Region (112) emittiert wird.

3. Anzeigebildschirm-Baugruppe (10) nach Anspruch 1, wobei das Kopplungsgitter (12) ferner konfiguriert ist, zu gestatten, dass ein externes Licht, das hin zu der zweiten Region (112) einfällt, zu der zweiten Region (112) durch das Kopplungsgitter (12) übertragen und durch die zweite Region (112) durchgelassen wird.

4. Anzeigebildschirm-Baugruppe (10) nach Anspruch 1, wobei die erste Region (111) mit einer Vielzahl von Bildpunkten (111b) angeordnet ist; und die zweite Region (112) nicht mit Bildpunkten angeordnet ist, und
wobei die zweite Region (112) eine durch die Vielzahl von Bildpunkten gebildete Lückenregion ist.

5. Anzeigebildschirm-Baugruppe (10) nach Anspruch 4, wobei der Anzeigebildschirm (11) ferner eine dritte Region (113) umfasst, die an einer Peripherie der ersten Region (111) angeordnet ist, wobei die dritte Region (113) mit einer Vielzahl von Bildpunkten (113a) angeordnet ist und eine Bildpunkttreiberschaltung der ersten Region (111) in der dritten Region (113) angeordnet ist.

6. Anzeigebildschirm-Baugruppe (10) nach Anspruch 5, wobei die erste Region (111) eine Vielzahl von Bildpunktgruppen (111c) umfasst, jede der Vielzahl von Bildpunktgruppen (111c) mindestens zwei Bildpunkte der Vielzahl der Bildpunkte umfasst und die mindestens zwei Bildpunkte in jeder der Vielzahl von Bildpunktgruppen (111c) parallel verbunden sind.

7. Anzeigebildschirm-Baugruppe (10) nach Anspruch 6, wobei eine Bildpunktdichte der dritten Region (113) gleich einer Bildpunktdichte der ersten Region (111) ist.

8. Anzeigebildschirm-Baugruppe (10) nach Anspruch 4, wobei eine reflektierende Schicht (111a) an einer Unterseite der Vielzahl von Bildpunkten (111b) in der ersten Region (111) angeordnet ist.

9. Anzeigebildschirm-Baugruppe (10) nach Anspruch 8, wobei die reflektierende Schicht (111a) Anoden der Vielzahl von Bildpunkten (111b) der ersten Region (111) umfasst.

10. Elektronische Vorrichtung (100), umfassend:
die Anzeigebildschirm-Baugruppe (10) nach einem der Ansprüche 1 bis 9;
eine optische Abbildungsvorrichtung (50), angeordnet an einer anderen Seite des Anzeigebildschirms (11), wobei die optische Abbildungsvorrichtung (50) zu der zweiten Region (112) weist und die optische Abbildungsvorrichtung (50) konfiguriert ist zum Empfangen von externem Licht, das durch die zweite Region (112) durchgelassen wird, um dadurch ein Bild zu erhalten.

11. Elektronische Vorrichtung (100) nach Anspruch 10, ferner umfassend:
eine Steuerschaltung (31), die mit der elektrisch gesteuerten lichtdurchlässigen Vorrichtung (13) elektrisch verbunden ist, wobei die Steuerschaltung (31) konfiguriert ist zum Steuern der elektrisch gesteuerten lichtdurchlässigen Vorrichtung (13), eingeschaltet oder ausgeschaltet zu sein, um dadurch zu bewirken, dass die elektrisch gesteuerte lichtdurchlässige Vorrichtung (13) dem externen Licht gestattet, hin zu der ersten Region (111) einzufallen, oder das externe Licht zu blockieren, hin zu der ersten Region (111) einzufallen.

12. Elektronische Vorrichtung (100) nach Anspruch 10, wobei die optische Abbildungsvorrichtung (50) konfiguriert ist zum Erfassen eines ersten Bilds als Reaktion darauf, dass die elektrisch gesteuerte lichtdurchlässige Vorrichtung (13) dem externen Licht gestattet, hin zu der ersten Region (111) einzufallen; und die optische Abbildungsvorrichtung (50) konfiguriert ist zum Erfassen eines zweiten Bilds als Reaktion darauf, dass die elektrisch gesteuerte lichtdurchlässige Vorrichtung (13) das externe Licht blockiert, hin zu der ersten Region (111) einzufallen;
wobei die elektronische Vorrichtung (100) ferner umfasst:
einen Prozessor (32), der mit der optischen Abbildungsvorrichtung (50) elektrisch verbunden ist, und wobei der Prozessor (32) konfiguriert ist zum Erzeugen eines endgültigen Bilds gemäß dem ersten Bild und dem zweiten Bild.

13. Bilderfassungsverfahren, angewandt auf die elektronische Vorrichtung (100) nach einem der Ansprüche 10 bis 12, und
wobei das Bilderfassungsverfahren umfasst:
Erfassen, als Reaktion darauf, dass die elektrisch gesteuerte lichtdurchlässige Vorrichtung (13) ausgeschaltet ist, eines ersten Bilds durch die optische Abbildungsvorrichtung (50);
Erfassen, als Reaktion darauf, dass die elektrisch gesteuerte lichtdurchlässige Vorrichtung (13) eingeschaltet ist, eines zweiten Bilds durch die optische Abbildungsvorrichtung (50); und
Erzeugen eines endgültigen Bilds gemäß dem ersten Bild und dem zweiten Bild.

14. Bilderfassungsverfahren nach Anspruch 13, wobei das Erzeugen eines endgültigen Bilds gemäß dem ersten Bild und dem zweiten Bild umfasst:
Entfernen von Bildinformationen korrespondierend mit dem zweiten Bild aus dem ersten Bild, um ein drittes Bild zu erhalten; und
Spleißen des zweiten Bilds und des dritten Bilds, um das endgültige Bild zu erhalten.

## Revendications

1. Ensemble d'écran d'affichage (10), comprenant :
un écran d'affichage (11), comprenant une première région (111) et une deuxième région (112), et le facteur de transmission lumineuse de la première région (111) étant inférieur au facteur de transmission lumineuse de la deuxième région (112) ;
un réseau de couplage (12), empilé sur un côté de l'écran d'affichage (11), dans lequel le réseau de couplage (12) est configuré pour coupler et transmettre une lumière externe incidente vers la première région (111) à la deuxième région (112) et la faire traverser la deuxième région (112) ; et
un dispositif de passage de lumière commandé électriquement (13), empilé sur un côté du réseau de couplage (12) détourné de l'écran d'affichage (11), dans lequel le dispositif de passage de lumière commandé électriquement (13) fait face à la première région (111), et est commutable entre un état de protection contre la lumière et un état de transmission de lumière ;
lorsque le dispositif de passage de lumière commandé électriquement (13) est désactivé, le dispositif de passage de lumière commandé électriquement (13) est dans l'état de transmission de lumière et est configuré pour permettre l'incidence de la lumière externe vers la première région (111) ; et lorsque le dispositif de passage de lumière commandé électriquement (13) est activé, le dispositif de passage de lumière commandé électriquement (13) est dans l'état de protection contre la lumière et est configuré pour bloquer l'incidence de la lumière externe vers la première région (111).

2. Ensemble d'écran d'affichage (10) selon la revendication 1, dans lequel le réseau de couplage (12) comprend une première région de couplage (121) et une deuxième région de couplage (122), la première région de couplage (121) fait face à la première région (111), la deuxième région de couplage (122) fait face à la deuxième région (112), la lumière externe incidente vers la première région de couplage (121) est couplée et transmise à la deuxième région de couplage (122), et la lumière externe est émise à partir de la deuxième région de couplage (122) vers la deuxième région (112).

3. Ensemble d'écran d'affichage (10) selon la revendication 1, dans lequel le réseau de couplage (12) est configuré en outre pour permettre la transmission d'une lumière externe incidente vers la deuxième région (112) à la deuxième région (112) à travers le réseau de couplage (12) et son passage à travers la deuxième région (112).

4. Ensemble d'écran d'affichage (10) selon la revendication 1, dans lequel la première région (111) est agencée avec une pluralité de pixels (111b) ; et la deuxième région (112) n'est pas agencée avec des pixels, et
dans lequel la deuxième région (112) est une région d'espace formée par la pluralité de pixels.

5. Ensemble d'écran d'affichage (10) selon la revendication 4, dans lequel l'écran d'affichage (11) comprend en outre une troisième région (113) disposée au niveau d'une périphérie de la première région (111), la troisième région (113) est agencée avec une pluralité de pixels (113a), et un circuit d'excitation de pixels de la première région (111) est disposé dans la troisième région (113).

6. Ensemble d'écran d'affichage (10) selon la revendication 5, dans lequel la première région (111) comprend une pluralité de groupes de pixels (111c), chacun de la pluralité de groupes de pixels (111c) comprend au moins deux pixels de la pluralité de pixels, et les au moins deux pixels de chacun des groupes de la pluralité de groupes de pixels (111c) sont connectés en parallèle.

7. Ensemble d'écran d'affichage (10) selon la revendication 6, dans lequel une densité de pixels de la troisième région (113) est égale à une densité de pixels de la première région (111).

8. Ensemble d'écran d'affichage (10) selon la revendication 4, dans lequel une couche réfléchissante (111a) est disposée au niveau d'une partie basse de la pluralité de pixels (111b) dans la première région (111).

9. Ensemble d'écran d'affichage (10) selon la revendication 8, dans lequel la couche réfléchissante (111a) comprend des anodes de la pluralité de pixels (111b) de la première région (111).

10. Dispositif électronique (100), comprenant :
l'ensemble d'écran d'affichage (10) selon l'une quelconque des revendications 1 à 9 ;
un dispositif d'imagerie optique (50), disposé sur un autre côté de l'écran d'affichage (11), dans lequel le dispositif d'imagerie optique (50) fait face à la deuxième région (112), et le dispositif d'imagerie optique (50) est configuré pour recevoir une lumière externe passant à travers la deuxième région (112) pour obtenir ainsi une image.

11. Dispositif électronique (100) selon la revendication 10, comprenant en outre :
un circuit de commande (31), connecté électriquement au dispositif de passage de lumière commandé électriquement (13), dans lequel le circuit de commande (31) est configuré pour commander l'activation et la désactivation du dispositif de passage de lumière commandé électriquement (13), afin de faire en sorte que le dispositif de passage de lumière commandé électriquement (13) permette l'incidence de la lumière externe vers la première région (111) ou bloque l'incidence de la lumière externe vers la première région (111).

12. Dispositif électronique (100) selon la revendication 10, dans lequel le dispositif d'imagerie optique (50) est configuré pour acquérir une première image en réponse à l'incidence autorisée par le dispositif de passage de lumière commandé électriquement (13) de la lumière externe vers la première région (111) ; et le dispositif d'imagerie optique (50) est configuré pour acquérir une deuxième image en réponse au blocage par le dispositif de passage de lumière commandé électriquement (13) de l'incidence de la lumière externe vers la première région (111) ;
le dispositif électronique (100) comprenant en outre :
un processeur (32), connecté électriquement au dispositif d'imagerie optique (50), et le processeur (32) est configuré pour générer une image finale en fonction de la première image et de la deuxième image.

13. Procédé d'acquisition d'images, appliqué au dispositif électronique (100) selon l'une quelconque des revendications 10 à 12, et
le procédé d'acquisition d'image comprenant :
l'acquisition, en réponse à la désactivation du dispositif de passage de lumière commandé électriquement (13), d'une première image à travers le dispositif d'imagerie optique (50) ;
l'acquisition, en réponse à l'activation du dispositif de passage de lumière commandé électriquement (13), d'une deuxième image à travers le dispositif d'imagerie optique (50) ; et
la génération d'une image finale en fonction de la première image et de la deuxième image.

14. Procédé d'acquisition d'images selon la revendication 13, dans lequel la génération d'une image finale en fonction de la première image et de la deuxième image comprend :
la suppression d'informations d'image correspondant à la deuxième image dans la première image pour obtenir une troisième image ; et
le raccordement de la deuxième image et de la troisième image pour obtenir l'image finale.
